(19) Europäisches Patentamt / European Patent Office / Office européen des brevets

(11) **EP 3 047 241 B1**

(12) **EUROPÄISCHE PATENTSCHRIFT**

(45) Veröffentlichungstag und Bekanntmachung des Hinweises auf die Patenterteilung:
**03.01.2018   Patentblatt 2018/01**

(21) Anmeldenummer: **14750480.7**

(22) Anmeldetag: **12.08.2014**

(51) Int Cl.:
*G01F 1/32* *(2006.01)*          *G01F 25/00* *(2006.01)*
*G01R 31/01* *(2006.01)*        *G01R 31/02* *(2006.01)*
*G01R 31/28* *(2006.01)*

(86) Internationale Anmeldenummer:
**PCT/EP2014/067228**

(87) Internationale Veröffentlichungsnummer:
**WO 2015/039814 (26.03.2015 Gazette 2015/12)**

(54) **VERFAHREN ZUR ÜBERWACHUNG EINES MESSGERÄTES DER AUTOMATISIERUNGSTECHNIK**

MONITORING PROCESS FOR A MEASUREMENT DEVICE IN AUTOMATION

PROCÉDÉ DE SUIVI D'UN DISPOSITIF DE MESURE DANS L'AUTOMATISATION INDUSTRIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.09.2013   DE 102013110243**

(43) Veröffentlichungstag der Anmeldung:
**27.07.2016   Patentblatt 2016/30**

(73) Patentinhaber: **Endress + Hauser Flowtec AG
4153 Reinach (CH)**

(72) Erfinder:
• **SCHMID, Hanspeter
  CH-5024 Küttigen (CH)**

• **TANNER, Werner
  CH-4460 Gelterkinden (CH)**
• **SÜTTERLIN, Dirk
  79650 Schopfheim (DE)**
• **KOCH, Martin
  4143 Dornach (DE)**

(74) Vertreter: **Andres, Angelika Maria
Endress+Hauser (Deutschland) AG+Co. KG
PatServe
Colmarer Strasse 6
79576 Weil am Rhein (DE)**

(56) Entgegenhaltungen:
**WO-A1-2007/021419     DE-A1- 3 544 198
US-B1- 8 461 849**

**Beschreibung**

Die Erfindung betrifft ein Verfahren zur Überwachung eines Messgeräts der Automatisierungstechnik, wobei das Messgerät einen kapazitiven Sensor aufweist, wobei der kapazitive Sensor zumindest einen Kondensator aufweist, und wobei der zumindest eine Kondensator zur Bestimmung oder Überwachung einer Prozessgröße eingesetzt wird. Weiterhin betrifft die Erfindung eine Vorrichtung zur Durchführung des Verfahrens zur Überwachung der Funktionstüchtigkeit des Messgeräts.

In der Prozess- ebenso wie in der Automatisierungstechnik werden vielfach Feldgeräte eingesetzt, die zur Erfassung und/oder Beeinflussung von Prozessgrössen dienen. Zur Erfassung von Prozessgrössen dienen Messgeräte, wie beispielsweise Füllstandsmessgeräte, Durchflussmessgeräte, Druck- und Temperaturmessgeräte, pH-Messgeräte, Leitfähigkeitsmessgeräte, usw., welche die entsprechenden Prozessgrössen Füllstand, Durchfluss, Druck, Temperatur, pH-Wert bzw. Leitfähigkeit erfassen. Zur Beeinflussung der Prozessgrössen werden Aktoren verwendet, wie Ventile oder Pumpen, über die z. B. der Durchfluss einer Flüssigkeit in einer Rohrleitung oder der Füllstand eines Mediums in einem Behälter geändert wird. Als Feldgeräte werden im Prinzip alle Geräte bezeichnet, die prozessnah eingesetzt werden und die prozessrelevante Informationen liefern oder verarbeiten. Eine Vielzahl solcher Feldgeräte wird von der Firmengruppe Endress + Hauser angeboten und vertrieben. Unter dem in Verbindung mit der Erfindung verwendeten Begriff Feldgerät sind somit alle Typen von Messgeräten und Aktoren zu subsumieren. Weiterhin umfasst der Begriff Feldgerät aber auch z. B. ein Gateway, einen Funkadapter oder andere in ein Bussystem integrierte/integrierbare Busteilnehmer.

In vielen industriellen Anlagen herrschen raue Einsatzbedingungen, so dass die Feldgeräte zum Teil sehr stark belastet und beansprucht werden. Während der Planung einer industriellen Anlage wird die Belastbarkeit der Feldgeräte, die eingesetzt werden sollen, sorgfältig abgewogen. Schwerpunkte dabei sind nicht nur die Haltbarkeit oder Beständigkeit der Feldgeräte an sich, sondern auch die Zuverlässigkeit und Funktionstüchtigkeit der entsprechenden Messtechnik, die in den Feldgeräten integriert ist. Themen wie Lebensdauer, Selbstüberwachung und vorausschauende Wartung spielen hier eine wichtige Rolle. Diese Abwägungen gelten insbesondere für die Messgeräte, die eingesetzt werden, um Prozessgrössen zu erfassen.

Wirbelströmungsmessgeräte beispielsweise werden eingesetzt, um die Durchflussgeschwindigkeit eines Mediums in einem Messrohr zu erfassen. Um abträgliche Auswirkungen zu vermeiden, muss die verwendete Messtechnik in Wirbelströmungsmessgeräten zuverlässige Messwerte liefern und funktionssicher sein. Konträr gesehen: in Anlagen, in denen Aktoren aufgrund der von Messgeräten erfassten Prozessgrößen dieselbe oder eine andere Prozessgröße beeinflussen sollen, kann es zu erheblichen Schäden kommen, wenn die Aktoren auf der Bases unzuverlässiger Messwerte arbeiten. In diesem Sinne müssen Wirbelströmungsmessgeräte auch in Anlagen, wie beispielsweise in einem Dampfkraftwerk, in denen die Leitungen zum Teil unter hohem Druck stehen und auf hohe Temperaturen beheizt werden, nicht nur funktionieren, sondern sie müssen auch zuverlässig arbeiten.

Das Beispiel eines Wirbelströmungsmessgerätes wird im Folgenden weiter vorangetrieben. Wirbelströmungsmessgeräte bestehen im Normalfall aus einem Messrohr mit einem in dem Messrohr angeordneten Staukörper. In Medien, die an diesem Staukörper vorbei fließen, bilden sich Wirbel, wenn das Medium bzw. der Durchfluss des Mediums bestimmte Bedingungen erfüllt.

Eine wichtige Rolle spielt in diesem Zusammenhang die Reynolds-Zahl. Die Reynolds-Zahl ist eine dimensionslose Größe, die das Verhältnis zwischen Trägheitskräften und Viskositätskräften eines Strömungssystems charakterisiert. Wenn die Reynolds-Zahl für dieses System in einem bestimmten Bereich liegt, werden Wirbel in dem Medium, das an dem Staukörper im Messrohr vorbeiströmt, gebildet. Die Wirbel sind derart, dass sie eine sogenannte Kármánsche Wirbelstraße bilden. Die Wirbel lösen sich abwechselnd von der Oberfläche einer ersten Seite des Staukörpers und von der Oberfläche einer zweiten Seite des Staukörpers ab. Daher weisen die Wirbel unterschiedliche Rotationsrichtungen auf, wobei die Wirbel immer mit gleichem Abstand voneinander abgelöst werden. Dies bedeutet, dass die Wirbelablösefrequenz nur durch eine Änderung der Durchflussgeschwindigkeit des strömenden Mediums beeinflusst wird. Die Wirbelablösefrequenz ist also direkt von der Durchflussgeschwindigkeit abhängig.

Messgeräte, die diese Wirbelablösefrequenz erfassen, weisen eine Sensorik bzw. Messtechnik auf, die die Druckschwankung infolge der Wirbelbildung erfasst. Es ist eine Sensorik bekannt geworden, die einen kapazitiven Sensor und ein Paddel aufweist. Das Paddel ragt in das Messrohr hinein und wird unter dem Einfluss der Wirbel von einer Seite zur anderen Seite bewegt. Die seitlichen Bewegungen werden über eine Kapazitätsänderung erfasst. Zumindest einen Kondensator zur Erfassung die Kapazitätsänderungen ist in einem Raum angeordnet, wobei der Raum dem Prozess gegenüber abgedichtet ist. Die Bewegung des Paddels wird zu einem beweglichen Element innerhalb dieses Raumes über eine Membrane transferiert. Die Membrane dient zum Abdichten des Raumes gegen den Prozess sowie zum Aufnehmen des Prozessdrucks.

In der Veröffentlichbungsschrift DE 035 44 198 A1 ist ein Wirbelstrommessgerät gezeigt, dass die Frequenz des Staukörpers und somit die Durchflussgeschwindigkeit im Messrohr kapazitv misst. Die dort gezeigte, spezielle Kondensatorelektroden-Anordnung erlaubt eine Messung der Durchflussgeschwindigkeit ohne Verfälschung durch Schwingungen bzw. Vibrationen, denen das gesamte Messgerät eventuell ausgesetzt ist.

Daneben ist in der US Patentschrift 8 461 849 B1 ein Verfahren beschrieben, dass zur Überwachung der Funktionsfähigkeit eines Kondensators durch gegebenenfalls mehrmaliges Laden und anschließendes Entladen sowie Ermittlung des Verlustwiderstandes dient. Dabei wird der Verlustwiderstand nach jeder Lade-Phase neu bestimmt. Die Bestimmung erfolgt dabei, indem der Haltestrom zur Erhaltung der Testspannung erfasst wird.

Messgeräte zur Erfassung von Prozessgrößen sind häufig mit Dichtungen ausgestattet. Die Dichtungen dienen dazu, Feuchte, die vom Prozess und/oder der Umgebung stammt, von den elektrischen, elektronischen oder auch mechanischen Bauteilen des Messgerätes fernzuhalten. Ist eine Dichtung defekt, kann Feuchte die Funktionstüchtigkeit des Messgerätes stark beeinflussen. Beispielsweise kann sich in einem Wirbelströmungsmessgerät die Membrane bei starker Belastung spalten, oder es bilden sich kleine Risse. So kann in einer Automatisierungsanlage der Fall auftreten, dass in der Anlage ein Ventil zu schnell auf oder zu gemacht wird. Als Folge hiervon bildet sich eine Druckwelle in einer Rohrleitung aus, die erhebliche Schäden anrichten kann. Unter anderem kann die Membran eines Wirbelströmungsmessgeräts beschädigt werden, wobei die Beschädigung zu kleinen Spalt-/Rissbildungen führen kann, so dass Medium durch die Spalten in den Innenraum eindringen kann. Die eingedrungene Feuchte kann Kurzschlüsse an den elektrischen und/oder elektronischen Bauteilen verursachen, oder über längere Zeiträume Korrosionsprozesse katalysieren.

Ein Leckstrom, der zwischen einer Messgeräte-Elektronik und einem an Masse geschalteten Messgerätgehäuse fließt, kann überwacht werden, um einen fehlerhafte Betriebszustand eines Messgerätes zu erkennen. Beispielsweise ist aus der WO 2009/135764 A1 ein Verfahren zum Überwachen eines, insb. als Mess- und/oder Schaltgerät der industriellen Mess- und Automatisierungstechnik ausgebildeten und/oder elektronischen, Messgeräts bekannt geworden. Bei der bekannten Lösung wird eine Potentialdifferenz zwischen dem Gehäuse und der Messgerät-Elektronik zum Bewirken eines Leckstroms erzeugt, wobei der Leckstrom durch eine durch Kondenswasser gebildete, elektrisch leitfähige Verbindung zwischen dem Gehäuse und der Messgeräte-Elektronik fließt. Weiterhin wird der fließende Leckstrom erfasst, und es wird ein digitaler Zustandswert unter Berücksichtigung des erfassten Leckstroms generiert. Nachfolgend wird ein Alarmsignal generiert, welches das Auftreten eines - insb. durch unerwünschte Bildung leitfähiger Beläge innerhalb des Gehäuses verursachten - Fehlers im Messgerät signalisiert.

Als nachteilig ist es bei dem bekannten Verfahren anzusehen, dass eine Strommessschaltung zur Erfassung des Leckstroms benötigt wird. Es wird weiterhin in diesem Verfahren nur darauf geachtet, ob momentan eine elektrische leitfähige Verbindung besteht oder nicht. Das Verfahren registriert einen Fehler nur im Falle eines Leckstroms, der zur Masse fließt. Die Durchführung einer vorausschauenden Wartung ist mit der bekannten Lösung nicht möglich.

Aus der US 2013/0207677 A1 ist ein Verfahren zum Erkennen einer Fehlfunktion eines elektrostatischen kapazitiven Sensors bekannt, wobei das Verfahren folgende Schritte umfasst:

- Ermitteln von einem ersten Ermittlungssignal in Abhängigkeit von einer elektrostatischen Kapazität, die über eine Ermittlungselektrode ermittelt wird, während eine erste elektrische Spannung an eine Schutzelektrode angelegt wird, die in der Nähe der Ermittlungselektrode vorgesehen ist;
- Ermitteln von einem zweiten Ermittlungssignal in Abhängigkeit von einer elektrostatischen Kapazität, die über die Ermittlungselektrode ermittelt wird, während eine zweite, von der ersten Spannung verschiedene elektrische Spannung an die Schutzelektrode angelegt wird; und
- Erkennen aufgrund des ersten Ermittlungssignals und des zweiten Ermittlungssignals, ob eine Störung der Ermittlungselektrode vorliegt.

Der Nachteil der zuvor beschriebenen Lösung ist darin zu sehen, dass eine zusätzliche Ermittlungselektrode vorgesehen. Zudem werden zumindest zwei verschieden Referenzspannungen benötigt.

Der Erfindung liegt die Aufgabe zugrunde, ein Verfahren und eine Vorrichtung vorzuschlagen, die die Funktionstüchtigkeit eines Messgerätes der Automatisierungstechnik überwacht, ohne dass zusätzliche Bauteile eingesetzt werden. Die Aufgabe wird erfindungsgemäß gelöst durch das Verfahren gemäß Anspruch 1 und durch die Vorrichtung gemäß Anspruch 9. Der Ladungszustand des zumindest einen Kondensators des erfindungsgemäßen Verfahrens kann über verschiedene Größen charakterisiert werden. Somit sind zumindest die Ladung auf dem Kondensator und/oder die Spannung über dem Kondensator unter dem in Verbindung mit der Erfindung verwendeten Begriff Ladungszustand zu subsumieren. Die Änderung des Ladezustands ist dementsprechend auf verschiedene Weisen zu bestimmen. Der Verlustwiderstand ist der Widerstand über dem Weg, über dem eine Leckstrom des Kondensators fließt, wobei ein Leckstrom ein elektrischer Strom ist, der über einen Weg fließt, der nicht zur Leitung von Strom vorgesehen ist. Die Information über eine Störung kann verschiedene Aspekte haben. Aus dieser Information kann sowohl das Auftreten einer Störung erkannt werden, als auch eine Tendenz ermittelt werden, dass sich die Funktionsfähigkeit des Sensors verschlechtert.

Das Verfahren wird erfindungsgemäß bei einem Messgerät eingesetzt, das einen kapazitiven Sensor aufweist. Dann kann das Verfahren mit den vorhandenen Bauteilen ausgeführt werden. Ein Wirbelströmungsmessgerät weist beispielsweise sowohl zumindest einen Kondensator auf, als auch die entsprechende Elektronik, die nötig ist, das Verfahren umzusetzen. Das Verfahren ermöglicht weiterhin eine gezielte Überwachung des zumindest einen Kondensators, wobei der zumindest eine Kondensator entweder zu definierten Zeitpunkten und/oder während eines definierten Zeitraums überwacht wird.

Eine vorteilhaften Weiterbildung des erfindungsgemäßen Verfahrens sieht vor, dass ein digitaler Diagnose-Wert zur Repräsentation der Änderung des Ladungszustands des zumindest einen Kondensators ermittelt wird, dass die Information über die Störung der Funktionstüchtigkeit des Messgerätes gewonnen wird, indem der Diagnose-Wert mit einem vorgegebenen Schwellwert verglichen wird, und

dass eine Fehlermeldung generiert wird, wenn der vorgegebene Schwellwert überschritten wird. Der digitale Diagnose-Wert kann beispielsweise in einer Auswerteeinheit ermittelt werden, indem der Quotient der Ladungszustände zu den zwei aufeinanderfolgenden Zeitpunkten gebildet wird. Eine Auswerteeinheit hält viele Möglichkeiten zur Ermittlung eines digitalen Diagnose-Wertes bereit.

Die Änderung des Ladezustands deutet im normalen Fall auf einen Abfall des Verlustwiderstandes hin. Der Schwellwert kann beispielsweise ein Wert sein, der gerätespezifisch bestimmt oder nach Bedarf eines Sicherheitsstandards justiert wird. Insbesondere repräsentiert der Schwellwert einen minimal zugelassenen Wert des Verlustwiderstands. Ein Überschreiten dieses Schwellwerts indiziert einen zu niedrigen Verlustwiderstand. Die generierte Fehlermeldung kann als Hinweis auf eine aufgetretene Störung und/oder als frühzeitiger Wartungshinweis dienen. Solche Fehlermeldungen sparen in der Regel sehr viele Kosten und viel Zeit.

Eine vorteilhafte Weiterbildung des erfindungsgemäßen Verfahrens sieht vor, dass die Differenz der Ladungszustände des Kondensators zu den zwei aufeinanderfolgenden Zeitpunkten bestimmt wird, und

dass aus der Differenz die Information über eine Störung der Funktionstüchtigkeit des Messgerätes gewonnen wird.

Die Bestimmung der Differenz kann analog erfolgen. Somit entsteht eine schnelle und einfache Möglichkeit, die Änderung der Ladungszustände als Differenz zu erfassen, wobei diese Möglichkeit auch noch den Vorteil hat, dass eine Ladungsinjektion kompensiert oder durch Subtrahieren eliminiert wird. Die Ladungsinjektion erfolgt aufgrund von Streukapazitäten oder Störimpulsen, die beispielsweise in Schaltungen mit analogen und digitalen Komponenten entstehen.

Gemäß einer vorteilhaften Weiterbildung wird ein die Differenz der Ladungszustände repräsentierender digitaler Differenz-Wert ermittelt, und die Information über eine Störung der Funktionstüchtigkeit des Messgerätes wird gewonnen, indem der Differenz-Wert mit einem vorgegebenen Schwellwert verglichen wird. Eine Fehlermeldung wird generiert, wenn der vorgegebene Schwellwert überschritten wird.

Die Differenz der Ladezustände deutet im normalen Fall auf eine Senkung des Verlustwiderstands hin. Der Schwellwert kann beispielsweise ein Wert sein, der gerätespezifisch bestimmt oder nach Bedarf eines Sicherheitsstandards justiert wird. Insbesondere repräsentiert der Schwellwert einen minimal zugelassenen Wert des Verlustwiderstands. Ein Überschreiten dieses Schwellwerts indiziert einen zu niedrigen Verlustwiderstand. Die generierte Fehlermeldung kann als direkte Warnung und/oder als frühzeitiger Wartungshinweis dienen. Beispielsweise kann an ein Messgerät, das mit einem Kondensator-Verlustwiderstand von 30 MΩ eine zeitlang zuverlässig funktionieren würde, eine Fehlermeldung ausgegeben werden, wenn beispielsweise der Verlustwiderstand unter 50MΩ fällt. Solche Fehlermeldungen sparen in der Regel Kosten und viel Zeit und können sogar lebensrettend sein. Das erfindungsgemäße Verfahren sieht vor, dass der Verlustwiderstand des zumindest einen Kondensators gemessen wird, indem der zumindest eine Kondensator mit einer Referenzspannung ein erstes Mal aufgeladen wird, die Ladung auf dem zumindest einen Kondensator nach einer ersten vorgegebenen Zeitspanne bestimmt wird,

der zumindest eine Kondensator mit der Referenzspannung ein zweites Mal aufgeladen wird, und

die Ladung auf dem zumindest einen Kondensator nach einer zweiten vorgegebenen Zeitspanne bestimmt wird, und dass die erste und zweite vorgegebene Zeitspanne unterschiedlich lang sind.

Die Referenzspannung wird von einer Referenzspannungsquelle ausgegeben, wobei Referenzspannungsquellen als fester Bestandteil eines Feldgerätes zählen, da diese benötigt werden, beispielsweise um den normalen Ablauf eines Messgerätes durchzuführen. Während der Zeitspannen entlädt sich der zumindest eine Kondensator. Die erste und zweite vorgegebene Zeitspanne sind unterschiedlich lang, so dass sich der zumindest eine Kondensator unterschiedlich lang entladen kann. Somit werden zum ersten und zweiten Zeitpunkt unterscheidende Ladungen bestimmt, denn die Entladung passiert unterschiedlich schnell in Abhängigkeit von dem vorher beschriebenen Verlustwiderstand. Das Entladen eines Kondensators wird mittels der sogenannten RC-Zeitkonstante charakterisiert. Die Ableitung der RC-Zeitkonstante und die physikalischen Prinzipien, auf die sich das erfindungsgemäße Verfahren stützt, sind dem Fachmann durchaus bekannt.

Bei dieser Messung des Verlustwiderstands spielt es keine Rolle, ob der Leckstrom zur Masse oder über einen Kurzschluss zu einem anderen Bauteil des Messgerätes fließt, weil nur die Ladung auf dem zumindest einen Kondensator gemessen wird. Der Weg, auf dem die fehlende Ladung verloren ging, ist unwesentlich. Genauso ist es für die Messzuverlässigkeit unwesentlich, wo die Ladung hingeströmt ist. Für die Messzuverlässigkeit ist es nur wichtig, dass der zumindest eine Kondensator über einen vorgegebenen Zeitraum eine vorgegebene Menge an Ladung speichern kann. Erfindungsgemäß ist die zweite vorgegebene Zeitspanne kürzer als die erste vorgegebene Zeitspanne, so dass der entsprechende zweite Zeitpunkt, zu dem die Bestimmung des Ladungszustandes des zumindest einen Kondensators durchgeführt wird, unmittelbar nach dem zweiten Aufladen des zumindest einen Kondensators stattfindet.

Der Begriff "Unmittelbar" wird in diesem Kontext am besten verstanden im Zusammenhang mit einem sogenannten Systemtakt der Sensorik. Messgeräte die einen Kondensator einsetzen, um eine Prozessgröße zu bestimmen, können auf zwei verschiedene Arten funktionieren. Entweder wird die Kapazität eines Kondensators kontinuierlich beobachtet, oder der Kondensator wird auf eine diskrete Art und Weise erfasst. Als Beispiel dieser diskreten Art und Weise wird ein Kondensator aufgeladen, entladen und wieder aufgeladen, wobei die Bestimmung der momentanen Kapazität des Kondensators im Zusammenhang mit dem Entladen passiert. Die Kapazität einer Kondensator kann kontinuierlich beobachtet werden, indem der Kondensator an einen Hochfrequenzstromkreis angeschlossen wird.

Die Erfindung ist besonderes vorteilhaft, wenn die Kapazität auf eine diskrete Art und Weise erfasst wird. In diesem Kontext ist der Systemtakt ein Takt, der angewendet wird, um das Aufaden und Entladen des zumindest einen Kondensators zu koordinieren. Dass die zweite Bestimmung "unmittelbar" nach dem zweiten Aufladen des zumindest einen Kondensators stattfindet, bedeutet dann in Verbindung mit der Erfindung, dass sie innerhalb eines Zeitraums erfolgt, der durch eine geringe Anzahl von Takten definiert oder definierbar ist. Eine geringe Anzahl sind beispielsweise 5 Takte, oder ist insbesondere 1 Takt. Das Systemstakt taktet ein Messgerät mit einer spezifischen Frequenz.

Läuft beispielsweise der Systemtakt bei einer Frequenz von 125 kHz, so wird alle 8 $\mu$s einen Takt stattfinden. Wird beispielsweise der zumindest eine Kondensator mit einem Takt aufgeladen, so wird er für 8 $\mu$s an die Referenzspannungsquelle angeschlossen. Ist "unmittelbar nach dem zweiten Aufladen des zumindest einen Kondensators" durch die geringe Anzahl von insbesondere 5 Takten definiert, dauert es maximal 40 $\mu$s bis der Ladungszustand bestimmt wird, nachdem der Kondensator ein zweites Mal aufgeladen wird.

Wenn die zweite Bestimmung des Ladezustands des zumindest einen Kondensators unmittelbar nach dem zweiten Aufladen erfolgt, hat das den Vorteil, dass keine zusätzliche Speichereinheit vorgesehen werden muss, um das Ergebnis der ersten Bestimmung zwischenzeitlich zu speichern.

Gemäß einer vorteilhaften Weiterbildung wird die erste Ladung, die auf dem zumindest einen Kondensator zu dem ersten Zeitpunkt bestimmt wird, sowie die zweite Ladung, die auf dem zumindest einen Kondensator zu dem zweiten Zeitpunkt bestimmt wird, auf einen Ladungsmesskondensator übertragen, und die erste und zweite Ladung werden subtrahiert, so dass dabei eine Differenz der Ladungszustände elektronisch ermittelt wird.

Die zwei Ladungen vom kapazitiven Sensor können auf einen Ladungsmesskondensator beispielsweise mittels einer Ladungsverstärkerschaltung übertragen und subtrahiert werden. Eine Ladungsverstärkerschaltung ist ein einfach integrierbares Bauteil, das in vielen Fällen schon als Bestandteil eines Messgeräts vorgesehen ist.

Eine vorteilhafte Weiterbildung des erfindungsgemäßen Verfahrens sieht vor, dass der zumindest eine Kondensator vermittels einer Ladungspumpe mit einer genau bestimmten elektrischen Ladung aufgeladen wird.

Die Ladungspumpe erfüllt die gleiche Funktion wie eine Referenzspannung und ermöglicht die genaue Bestimmung der Ladung, die auf den Kondensator geladen wird. Es gibt verschiedene Ausgestaltungen einer Ladungspumpe, die dem Fachmann bekannt sind.

Die Verwendung einer Ladungspumpe ermöglicht weiterhin die Verwendung des erfingsgemäßes Verfahrens auch in dem Fall, das sich die gesamte Kapazität zwischen dem ersten und zweiten Zeitpunkt des Verfahrens verändert.

Eine vorteilhafte Weiterbildung des erfindungsgemäßen Verfahrens sieht vor, dass ein Ladungszustands-Wert zur Repräsentation des Ladungszustands des Kondensators ermittelt wird und dass der Ladungszustands-Wert zum ersten Zeitpunkt mit einem ersten vorgegebenen Grenzwert oder zum zweiten Zeitpunkt mit einem zweiten vorgegebenen Grenzwert verglichen wird, und aus diesem Vergleich die Information über eine Störung der Funktionstüchtigkeit des Messgerätes gewonnen wird.

Es kann vorkommen, dass der Verlustwiderstand des zumindest einen Kondensators niedrig genug ist, dass der Ladezustand nur einmal bestimmt werden muss, um zu erkennen, dass die Funktionstüchtigkeit des Kondensators gestört ist. Für diesen Fall wird ein Ladezustands-Wert ermittelt und mit einem Grenzwert verglichen. Dieser Grenzwert wird festgelegt in Bezug auf die entsprechende Kondensatorausgestaltung, bei der es verwendet wird. Bei Mitwirkung einer vorher beschriebenen Ladungspumpe wäre es möglich, den Grenzwert unabhängig von der messgerätespezifischen Ausgestaltung festzulegen.

Diese Weiterbildung ist insbesondere vorteilhaft in dem Fall, dass ein Kurzschluss über dem zumindest einen Kondensator ensteht. Ein Kurzschluss bedeutet hier nichts anderes, als dass der Verlustwiderstand einen sehr geringen Wert aufweist. In diesem Fall kann es vorkommen, dass die Änderung des Ladungszustands zwischen dem ersten Zeitpunkt und dem zweiten Zeitpunkt unauffällig ist, obwohl der Verlustwiderstand sehr niedrig ist. Dies folgt aus einer zu schnellen Entladung des zumindest einen Kondensators, so dass beide Bestimmungen des Ladungszustands zu Zeitpunkten erfolgen, in denen die Entladung großteils schon erfolgt ist. Ein Bereich der Verlustwiderstände, in dem dieses Phänomen erscheint bzw. in dem diese Weiterbildung besondere Vorteile bringt, ist anhand messgerätspezifischer Grössen, wie beispielsweise der RC-Zeitkonstante, festzulegen.

Eine vorteilhafte Weiterbildung des erfindungsgemäßen Verfahrens sieht vor, dass der Verlustwiderstand des zumindest einen Kondensators im zeitlichen Verlauf aufgezeichnet wird, und anhand einer abfallenden Tendenz des Verlustwiderstandes über die Zeit eine vorausschauende Wartungsmeldung ausgelöst wird. Verlustwiderstands-Werte, die den gemessenen Verlustwiderstand repräsentieren, können beispielsweise mittels einer Auswerteeinheit und einer Anzeigeeinheit im zeitlichen Verlauf graphisch dargestellt werden.

Eine Auskunft hinsichtlich einer Restzeit kann mittels einer Schätzfunktion ausgegeben werden, wobei diese Restzeit die übrige Lebensdauer charakterisiert bzw. die übrige Zeit, bis der zumindest eine Kondensator eine Prozeßgrösse nicht mehr zuverlässig bestimmen und überwachen kann. Die Schätzfunktion kann die Auskunft beispielsweise anhand einer Extrapolierung einer Kurve, die an die Verlustwiderstands-Werte angepasst ist, generieren.

In industriellen Anlagen kann die Zeit, die nötig ist, um ein Messgerät auszutauschen, erhebliche Kosten verursachen. Eine vorausschauende Wartungsmeldung ermöglicht eine Minimalisierung von solchen Kosten. Zum Beispiel können anhand der vorausschauenden Wartungsmeldung in einer Anlage, in der mehrere Messgeräte installiert sind, zwei oder mehrere Messgeräte gleichzeitig ausgetauscht oder repariert werden.

Gemäß einer vorteilhaften Weiterbildung der erfindungsgemäßen Vorrichtung führt die Regel-/Auswerteeinheit die Messung des Verlustwiderstandes des zumindest einen Kondensators derart aus, dass die Zeitdauer zwischen dem Beginn des Aufladeverfahrens und dem zweiten Zeitpunkt des Aufladeverfahrens weniger als eine halbe Wirbelablöseperiode beträgt. Das Aufladeverfahren beginnt zu einem Zeitpunkt, zudem der zumindest eine Kondensator mit einer Referenzspannung ein erstes Mal aufgeladen wird.

Der kapazitive Sensor des Wirbelströmungsmessgeräts funktioniert auf die oben beschriebene Art und Weise, indem der Sensor ein Paddel aufweist, wobei dieses Paddel sich aufgrund der Druckänderungen hin und her bewegt. Während das Paddel sich bewegt, wird es im Verlauf des normalen Messablaufs ständig geladen und entladen. Dabei wird die Kapazität des zumindest einen Kondensators regelmäßig geprüft. Wenn sich die Wirbelablösefrequenz über die Zeit stabilisiert, nehmen die Änderungen der Kapazität einem periodischen Charakter an, da das Paddel auf eine regelmäßigen Art und Weise hin und her schwebt. Im Prinzip muss, um die Wirbelablösefrequenz zu erfassen, der kapazitive Sensor nur prüfen, wie oft der zumindest eine Kondensator eine bestimmte Kapazität aufweist. Tritt also eine regelmäßige Registrierung eines wiederkehrenden Punktes in der periodischen Änderungen der Kapazität auf, so reicht dies aus, um die Wirbelablösefrequenz zu bestimmen. In Verbindung mit der Erfindung bezeichnet der Begriff "Nulldurchgang" dieses Auftreten. Also werden die Nulldurchgänge gezählt, um die Wirbelablösefrequenz zu bestimmen.

Der normale Messablauf des kapazitiven Sensors kann sich nicht vom Beginn des Aufladeverfahrens bis dem zweiten Zeitpunkt, zu dem der Ladungszustand des zumindest einen Kondensators bestimmt wird, abspielen. Daher ist die Weiterbildung besonders vorteilhaft, denn es ermöglicht die Durchführung des erfindungsgemäßen Verfahrens, ohne einen Fehler in der eigentlichen Messfunktion des Messgerätes einzuleiten.

Eine vorteilhafte Weiterbildung der erfindungsgemäßen Vorrichtung sieht vor, dass das Messgerät eine Schaltungsanordnung aufweist mit zwei Kondensatoren, die sich an einen gemeinsamen Knoten oder eine gemeinsame Elektrode anschließen, wobei der gemeinsame Knoten oder die gemeinsame Elektrode an Masse angeschlossen ist, dass die Kondensatoren an eine Referenzspannungsquelle über ein erstes Schalterelement angeschlossen sind, und dass die Kondensatoren an einen Ladungsverstärker über ein zweites Schalterelement angeschlossen sind.

Gemäß einer Weiterbildung ist der Ladungsverstärker in einer ASIC-Schaltung integriert. Gemäß einer Weiterbildung weist die ASIC-Schaltung einen Analog/Digital-Wandler auf, der an dem Ladungsverstärker angeschlossen ist, und der Analog/Digital-Wandler ist an einen als Auswerteinheit dienenden Mikrocontroller oder Signalprozessor angeschlossen. Die Erfindung wird anhand der nachfolgenden Figuren näher erläutert. Es zeigt:

Fig. 1: ein aus dem Stand der Technik bekannten Wirbelströmungsmessgerät,

Fig. 2: einen Längsschnitt durch das Messrohr eines Wirbelströmungsmessgerät,

Fig. 3: die Wirbel, die sich hinter dem Paddel bilden, und ihre Rotationsrichtungen,

Fig. 4: eine perspektivische Ansicht des Messgerätes entsprechend den in Fig. 1 gekennzeichneten Blickwinkel Z.

Fig. 5: ein repräsentatives Schaltungsdiagramm für das in Fig. 4 gezeigtem Messgerät 1

Fig. 6: ein Schaltungsdiagramm der Eingangsschaltung 12 des Wirbeldurchflusmessgerätes

Fig. 7a-b: ein Phasendiagramm eines normalen Messablaufs und eines Gesamptkapazitätmessablaufs,

Fig. 8a-c: ein Ausführungsbeispiel des erfindungsgemäßen Verfahrens und eine graphische Darstellung der Spannung über den Kondensatoren im zeitlichen Verlauf,

Fig. 9: ein Schaltdiagramm einer bevorzugten Ausführungsform der Vorrichtung zum Ausführen des erfindungsgemäßen Verfahrens, und

Fig. 10: eine graphische Darstellung einer Differenzkurve in Abhängigkeit von dem Verlustwiderstand.

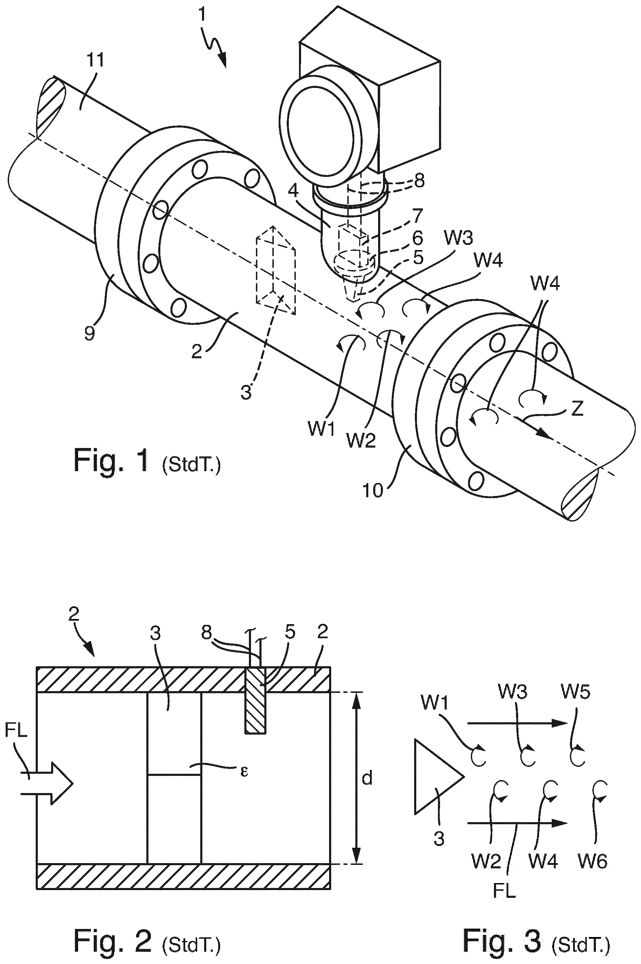

In Fig. 1 ist ein Wirbelströmungsmessgerät 1 dargestellt. Das Messgerät 1 weist ein Messrohr 2, einen Staukörper 3 und einen kapazitiven Sensor 4 auf. Der Sensor 4 weist ein Paddel 5 auf, das in das Messrohr 2 hineinragt. Das Paddel 5 ist an eine Membrane 6 angekoppelt. Diese Membrane 6 dient dazu, das Messrohr 2 abzudichten, sodass es hermetisch-/druckdicht ist. Der Sensor 4 weist weiterhin zwei elektrische Drähte 8 auf, die an zwei Kondensatorelektroden K1, K2 angeschlossen sind, wobei die Kondensatorelektroden K1, K2 in Fig. 1 nicht zu erkennen sind. Die nicht dargestellten Kondensatorelektroden K1, K2 bilden zwei Kondensatoren Cs1, Cs0, die eine gemeinsam dritten Elektrode K3, 7 aufweisen. Die dritte Kondensatorelektrode K3 ist auch an die Membran 6 gekoppelt. Üblicherweise sind die drei Gegenstände Paddel 5, Membran 6 und diese dritte Elektrode K3, 7 alle aus demselben elektrisch leitfähigen Material. Das Messrohr 2 ist in ein Rohr 11 in einer Anlage mittels einer ersten und einer zweiten Flanschverbindung 9, 10 eingebaut.

In Fig. 1 sind weiterhin Wirbel W1, W2, W3, W4 dargestellt. Die Wirbel W1, W2, W3, W4 werden in dem Medium gebildet, das durch das Messrohr durchfliesst. Das Medium fliesst von links nach rechts. Wenn das Medium an dem Staukörper 3 vorbeifliesst, werden die Wirbel W1, W2, W3, W4 abwechselnd von der Oberfläche des Staukörpers 3 abgelöst. Der Wirbel W1, der dem Staukörper 3 am nächsten liegt, wurde gerade von der hinteren Seite des Staukörpers abgelöst. Ein Pfeil zeigt die Rotationsrichtung dieses Wirbels W1 an. Die drei weiteren dargestellten Wirbel W2, W3, W4 weisen abwechselnd gegensinnige Rotationsrichtungen auf. Diese werden entsprechend von unterschiedlichen Seiten des Staukörpers 3 abgelöst.

Fig. 2 zeigt ein Längsschnitt des Messrohrs 2 eines Wirbelstromdurchflussmessgeräts. Wie in Fig. 1 strömt das Medium an dem Staukörper 3 von links nach rechts vorbei. Das Paddel 5 und die zwei elektrischen Drähte 8 sind ebenfalls dargestellt.

Medien, die durch das Messrohr 2 strömen, werden über die Reynolds-Zahl beschrieben. Die Reynolds-Zahl ist eine dimensionslose Zahl, deren Ableitung aus der Navier-Stokes Gleichung dem Fachmann bekannt ist. In dem in Fig. 2 dargestellten Messrohr 2 wird die Reynolds-Zahl für ein durchströmendes Medium mit Hilfe der folgenden Gleichung berechnet:

$$Re = (\rho * V * d) / \eta$$

Hierbei ist:

$\rho$ die charakteristische Dichte des Mediums in Kilogramm pro Kubikmeter,
V die charakteristische Durchflussgeschwindigkeit des Mediums gegenüber dem Messrohr 2 in Meter pro Sekunde;
d der innere Durchmesser d des Messrohrs 2 in Meter; und
$\eta$ die charakteristische dynamische Viskösität des Mediums in Kilogramm pro Sekunde pro Meter;.

Wirbel lösen sich von dem Staukörper 3 über einen grossen Bereich von Reynolds-Zahlen ab, beispielsweise zwischen 47 und 10^7. Die Ablösefrequenz f kann nach der Gleichung:

$$Sr = (f * \xi) / V$$

berechnet werden, wobei:

f der Wirbelablösefrequenz in Hertz entspricht,
$\xi$ eine charakteristische Abmessung des Staukörpers 3 in Meter ist,
V die charakteristische Durchflussgeschwindigkeit des Mediums gegenüber dem Messrohr 2 in Meter pro Sekunde ist; und
Sr die Strouhal-Zahl ist, wobei die Strouhal-Zahl mit der Reynolds-Zahl für eine vorgebenen Geometrie korreliert. Diese Korrelation wird experimentell bestimmt und nimmt meistens die Form:

$$Sr = m [1 - (n / Re)]$$

an, wobei

m und n reale Zahlen sind. Beispielsweise gilt:

$$Sr = 0,198*[1 - (19,7/Re)] \text{ für } 250 < Re < 2 \times 10^5,$$

wobei die Genauigkeit der experimentell bestimmten Korrelation immer eine Rolle spielt.

Als charakteristische Abmessung des Staukörpers 3 wird eine sogenannte charakteristische Breite $\xi$ verwendet. Für einen zylindrischen Staukörper 3 ist das der einfache Durchmesser des Staukörpers 3. In Fig. 2 ist ein charakteristische Breite $\xi$ beispielseweise als Durchmesser dargestellt.

Wenn die Reynolds-Zahl in einem bestimmten Bereich liegt, werden Wirbel W von dem Staukörper 3 mit einem bestimmten Frequenz f abgelöst, wobei

$$f = Sr * (V/ \xi)$$

gilt.

Die Frequenz f wird von einem kapazitiven Sensor 4 aufgenommen. In Fig. 2 sitzen das Paddel 5 und der kapazitive Sensor 4 direkt hinter dem Staukörper 3. Die vom Staukörper 3 abgelösten Wirbel W1-W4 üben Kräfte auf das Paddel 5 aus, und verursachen dabei leichte Schwankungen.

Die Wirbel W1-W6 und ihre Rotationsrichtungen sind in Fig. 3 dargestellt.

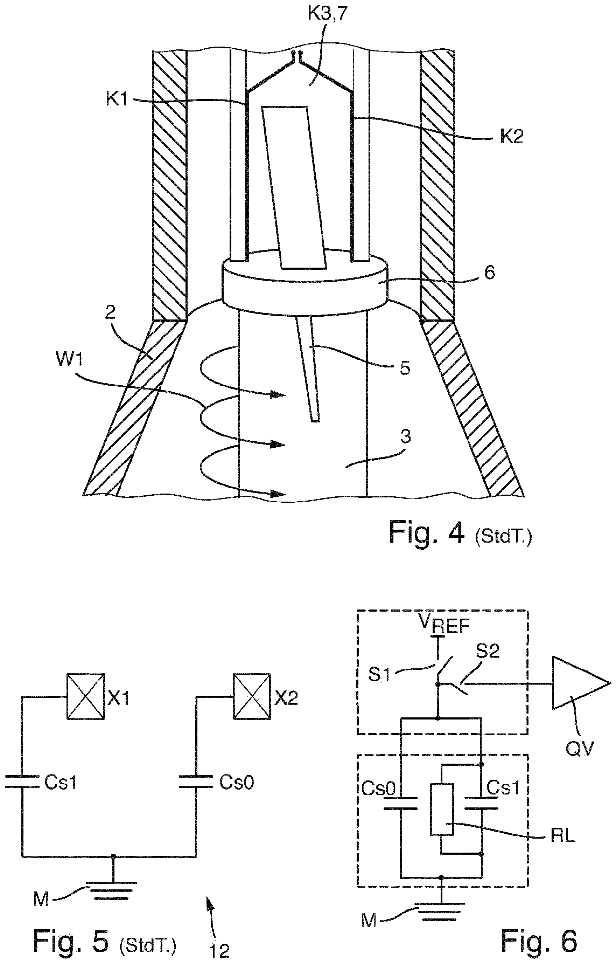

Fig. 4 zeigt eine perspektivische Ansicht des Messgerätes entsprechend den in Fig. 1 gekennzeichneten Blickwinkel Z.. Zu sehen sind die zwei Kondensatorelektroden K1, K2 und ebenso die zwei dazugehörigen, elektrischen Drähte 8. In Fig. 4 ist weiterhin ein Wirbel W1 dargestellt. Die Pfeile sind vorgesehen, um die Rotationsrichtung des Wirbels W1 anzuzeigen. Der Wirbel W1 drückt das Paddel 5 zur Seite. Um die Wirkung der Druckkräfte zu verdeutlichen, ist die Bewegung des Paddels 5 überbetont/übertrieben dargestellt. In einem realen Messgerät ist die Bewegung des Paddels 5 kaum zu erkennen. Diese Bewegung wird über die Membran 6 an einen Stab 7 weitergegeben, der zwischen der ersten und der zweiten Elektroden K1,K2 der Kondensatoren Cs0, Cs1 sitzt. Dieser Stab 7 dient als dritte Elektrode K3, wobei der Stab 7 von den zwei Kondensatorelektroden K1,K2 gemeinsam geteilt wird. Somit gibt es zwei Kondensatoren Cs1, Cs0. Die Kapazität der zwei Kondensatoren Cs1, Cs0 ändert sich mit der Bewegung des Stabes 7. Die Wirbelablösefrequenz f kann also anhand der Änderungen der Kapazität bestimmt werden.

Fig. 5 zeigt ein repräsentatives Schaltungsdiagramm für das in Fig. 4 gezeigte Messgerät 1. Die Schaltung kann als "Eingangsschaltung" 12 bezeichnet werden. In der Eingangsschaltung gibt es einen ersten Kondensator Cs1 und einen zweiten Kondensator Cs2. Die beiden Kondensatoren Cs1, Cs2 haben eine gemeinsame Elektrode K3, die an Masse M liegt. Diese Elektrode K3 repräsentiert den Stab 7 von Fig. 4.

Wie bereits oben beschrieben, kann eine Änderung der Kapazität auf eine diskrete Art und Weise erfasst werden. In Fig. 5 weist der erste Kondensator Cs1 einen ersten Anschluss X1 und der zweite Kondensator Cs0 einen zweiten Anschluss X2 auf. Über diese beiden Anschlüsse X1, X2 werden die Kondensatoren Cs1, Cs0 mit einer Referenzspannung $V_{REF}$ geladen und dann zur Bestimmung der Kapazität entladen. Die Anschlüsse X1, X2 können beispielseweise an einer ASIC-Schaltung (aus dem Englischen für "Application Specific Integrated Circuit") angeschlossen werden.

Fig. 6 zeigt ein Schaltungsdiagramm der Eingangsschaltung 12 des Wirbelstromdurchflusmessgerätes 1. In Fig. 6 sind die zwei Anschlüsse X1, X2 von Fig. 5 zusammengeschlossen. Bemerkenswert ist, dass die Gesamtkapazität der zwei Kondensatoren Cs0, Cs1 unverändert bleibt. Sind die zwei Anschlüsse X1, X2 zusammengeschlossen, können die zwei Kondensatoren Cs0, Cs1 gemeinsam an einer Referenzspannungsquelle $V_{REF}$ über ein erstes Schalterelement S1 angeschlossen werden. Folglich können die Kondensatoren mit der Referenzspannung $V_{REF}$ aufgeladen werden. Ein Verlustwiderstand $R_L$ ist in Fig. 6 dargestellt. Wie oben beschrieben, stellt der Verluststrompfad keinen vorgesehenen Strompfad dar, sondern einen Weg über den ein Leckstrom fließt.

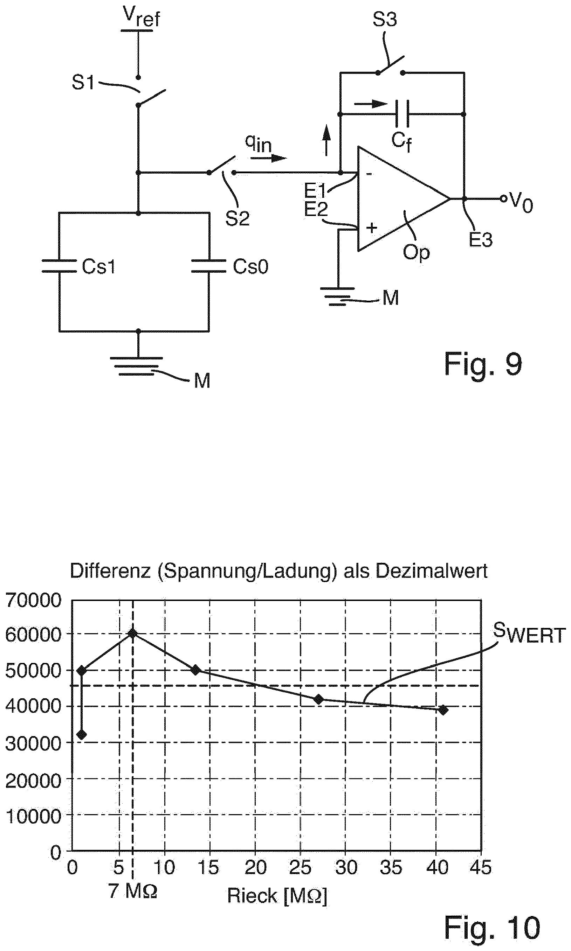

Fig. 6 zeigt weiterhin ein zweites Schalterelement S2. Über diesen zweiten Schalterelement S2 können die zusammengeschlossenen Anschlüsse X1, X2 der zwei Kondensatoren Cs0, Cs1 an einem Ladungsverstärker Qv angeschlossen werden. Eine Ausgestaltung des Ladungsverstärkers Qv ist in Fig. 9 gezeigt. Die Funktion des Ladungsverstärkers Qv wird in Verbindung mit Fig. 9 beschrieben.

In einem Wirbelstromdurchflussmessgerät 1 ist es nur nötig, die Wirbelablösefrequenz f zu bestimmen. Das kann auf verschiedene Arten passieren. Beispielsweise können in einem Wirbelstromdurchflussmessgerät 1 mit zwei Kondensatoren Cs0, Cs1 die Nulldurchgänge gezählt werden. Die Anordnung der Kondensatoren Cs0, Cs1, die in Figuren 4 bis 6 dargestellt sind, können als DSC-Sensor (aus dem Englischen für "Differential Switched Capacitor Sensor") bezeichnet werden. Ein Nulldurchgang kommt vor, wenn die Kapazität der zwei Elektroden K1, K2 gleich ist. Das passiert immer dann, währendessen der Stab 7 von einer Seite zu den anderen Seite schwingt. Das entspricht selbstverständlich die Bewegung des Paddels 5 und ferner der Ablösung eines Wirbels vom Staukörper 3. Also enspricht ein Nulldurchgang einem Wirbel.

Eine Möglichkeit, einen Nulldurchgang zu erkennen, besteht darin, dass, nachdem die zwei Kondensatoren Cs0, Cs1 aufgelanden sind, die zwei Anschlüsse X1, X2 an einen Komparator angeschlossen werden. Dieses Ausführungsbeispiel ist nicht abgebildet. Somit wird anhand eines Pegelwechsels in dem Ausgangssignal des Komparators ein Nulldurchgang erkannt. Eine solche Ausgestaltung hat den Nachteil, dass sie durch Rauschen leicht störbar ist. Weiterhin ist es möglich, dass sich der Mittelpunkt des Stabs 7 auf eine schleichende Art und Weise verändert.

Der Mittelpunkt des Stabs 7 ist die Ruheposition des Stabs 7 oder die Position des Stabs 7 in Abwesenheit von Druckkräften. Der Mittelpunkt des Stabs 7 entspricht weiterhin der Position, bei der die Kapazitäten der Kondensatoren Cs0, Cs1 einander gleich sind. Es ist möglich, dass bei dem Mittelpunkt des Stabs 7 die Kapazitäten verschieden sind. In diesem Fall wird von einem "statischen Offset" gesprochen.

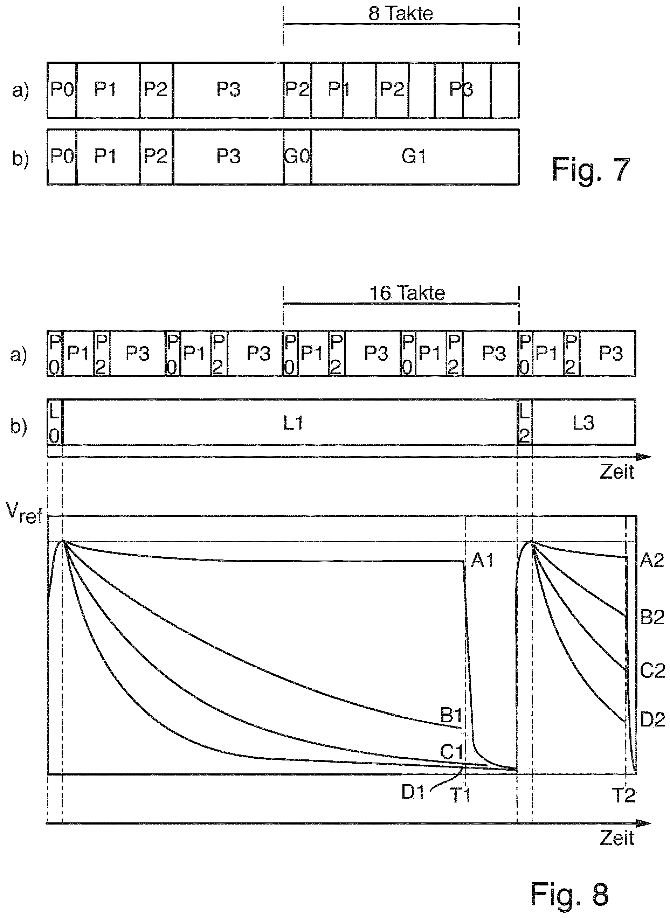

Eine zweite Möglichkeit, die Nulldurchgänge zu zählen, wird anhand des in Fig. 7a,b dargestellten Messablaufes beschrieben. In Fig. 7a sind vier Blöcke, die vier verschiedene Phasen P0, P1, P2, P3 des Messablaufs darstellen, gezeigt. Die Breite der Blöcke entspricht einem Zeitraum, indem eine Phase P0, P1, P2, P3 abläuft. Die vier Phasen P0, P1, P2, P3 werden kontinuierlich wiederholt. In Fig. 7a ist nur eine Wiederholung dargestellt.

In der erste Phase P0 des Messablaufs werden die zwei Kondensatoren Cs0, Cs1 mit unterschiedlichen Spannungen aufgeladen. Hierbei wird der erste Anschluss X1 an einer positiven oder negativen Referenzspannung $V_{POS}$, $V_{NEG}$ angeschlossen, und das zweite Anschluss X2 wird dementsprechend an einer negativen oder positiven Referenzspannung $V_{NEG}$, $V_{POS}$ angeschlossen. Also wird der eine Kondensator Cs0, Cs1 positiv und der andere Kondensator Cs1, Cs0 negativ geladen, wobei der absolute Betrag der positiven und negativen Referenzspannungen $V_{POS}$, $V_{NEG}$ gleich ist.

In der zweiten Phase P1 werden die Kondensatoren Cs0, Cs1 entladen. Beim Entladen wird die Ladung der zwei Kondensatoren Cs0, Cs1 zusammen auf einen Ladungsmesskondensator $C_f$ geladen. Somit wird eine Differrenz der Kapazitäten ermittelt. Die Ladungen werden auf dem Ladungsmesskondensator $C_f$ addiert, wobei die Ladungen entgegengesetzt sind. Also kommt es zu einer ersten Ladungsdifferenz des absoluten Betrages der Ladung, die ferner einer Differenz der Kapazitäten entspricht.

In der dritten Phase P2 werden die Kondensatoren Cs0, Cs1 wieder aufgeladen. Der dritte Phase P2 ist eine Spiegelung der erste Phase P0. Der Kondensator Cs0, Cs1, der mit einer positiven Ladung in der erste Phase P0 geladen wurde, wird in der dritten Phase P2 mit einer negativen Ladung geladen. Genauso wird der andere Kondensator Cs1, Cs0, der zuerst negativ geladen wurde, in der dritten Phase P2 positive geladen.

In der vierte Phase P3 werden die Kondensatoren Cs0, Cs1 nochmal entladen, und eine zweite Ladungsdifferenz des absoluten Betrages der Ladung, die ferner einer Differenz der Kapazität entspricht, wird bestimmt. In der vierten Phase P3 werden weiterhin die erste und zweite Ladungsdifferenz der zweiten und vierten Phasen P1, P3 voneinander subtrahiert. Die Ladungsdifferenz der zweiten Phase P1 weist eine Ladung auf, die entgegengesetzt zu der Ladungsdifferenz der vierten Phase P3 ist. Somit wird bei einer Subtraktion der ersten Ladungsdifferenz von der zweiten Ladungsdifferenz, oder ebenso der zweiten von der ersten, eine Addition des absoluten Betrages der zwei Ladungsdifferenzen erfolgen. Das dient dazu, das Messsignal zu verstärken sowie vorhandene Störelemente wie Ladungsinjektion oder ein Offset zu unterdrücken oder zu eliminieren.

Das Messsignal wird selbstverständlich aufgenommen und weiterbearbeitet, bspw. digitalisiert. Vorzugsweise läuft der normale Messablauf mehrmals innerhalb eines Zeitraumes durch, der von dem Kehrwert der Wirbelablösefrequenz definiert ist. Anders betrachtet, soll das Wirbelstromdurchflussmessgerät 1 mehrere Ladungsdifferenzen aufnehmen, und zwar zwischen den Zeitpunkten, zu denen ein erster Wirbel W2 abgelöst wird und ein zweiter Wirbel W1 abgelöst wird. So wird die Position des Paddels 5 zu vielen Zeitpunkten bestimmt und die Nulldurchgänge gezählt.

Nachfolgend wir ein Beispiel beschrieben. Wenn ein Wirbelstromdurchflussmessgerät 1 mit einem Staukörper 3, der eine charakteristische Breite $\xi$ von ca. 3mm aufweist, Durchflussgeschwindigkeiten bis zu 125 m/s erfassen soll, muss das Paddel 5 Wirbelablösefrequenzen f über einen Bereich von ca. 1 Hz bis ca. 4000 Hz aufnehmen können. Das Paddel 5 und Membran 6 als Masse-Feder-System müssen daher eine entsprechenden Resonanzfrequenz - mehr als 4000 Hz - aufweisen. Weiterhin soll der normale Messablauf innerhalb eines Zeitraums, der (1/4000) Sekunden beträgt, mehrmals durchlaufen. Läuft der Messablauf mindestens viermal in diesem (1/4000) Sekunden langen Zeitraum durch, wird entsprechend mindestens ein Durchlauf alle (1/16000) Sekunden stattfinden müssen. Wie in Fig. 7a dargestellt, benötigt ein Durchlauf des Messablaufs mindestens 8 Takte eines Systemtakts. Es folgt daher, dass ein Systemtakt von mindestens 128 kHz vorliegen muss.

In Fig. 7b läuft der normale Messablauf einmal durch. Der normale Messablauf wird dannach abgebrochen, und ein Messablauf zur Bestimmung der Gesamptkapazität der zwei Kondensatoren wird durchgeführt. Dieser Messablauf besteht aus zwei Phasen G0, G1. In der ersten Phase G0 werden die beiden Anschlüsse der Kondensatoren Cs0, Cs1 zusammen an einer Referenzspannungsquelle $V_{REF}$ angeschlossen. Die Kondensatoren Cs0, Cs1 werden dadurch auf eine Referenzspannung $V_{REF}$ geladen. In der zweiten Phase G1 werden die Kondensatoren Cs0, Cs1 entladen. Dabei wird die Gesamptkapazität der Kondensatoren Cs0, Cs1 bestimmt. Ein Gesamptkapazitäts-Wert oder ein Ladungszustands-Wert zur Repräsentation der Gesamtladung der Kondensatoren Cs0+Cs1 kann dann ermittelt und hinterlegt werden. Die Gesamptkapazitätmessung ist wichtig nicht nur um einer Kurzschluss zu erkennen, wie bereits oben beschrieben, sondern auch um einen statischen Offset zu berechnen.

Figuren 8a und 8b zeigen ein Ausführungsbeispiel des erfindungsgemäßen Verfahrens. In Fig. 8a läuft der normale Messablauf regelmäßig durch. In Fig. 8b wird dieser normale Durchlauf abgebrochen und durch einen Messablauf zur Bestimmung eines Leckstroms ersetzt. Der Messablauf besteht aus vier Phasen L0, L1, L2, L3.

In der erste Phase L0 werden auf die gleiche Art und Weise wie in der erste Phase des Messablaufs zur Bestimmung der Gesamptkapazität G0 die beiden Anschlüsse X1, X2 der Kondensatoren Cs0, Cs1 zusammen an eine Referenzspannungsquelle $V_{REF}$ angeschlossen und die Kondensatoren dadurch auf ein Referenzspannung $V_{REF}$ geladen.

In der zweite Phase L1 wird eine erste Zeitspanne zunächst abgewartet. Nach dieser ersten Zeitspanne, zu einem ersten Zeitpunkt T1, wird der Ladungszustand der zwei Kondensatoren ermittelt, indem die Kondensatoren Cs0, Cs1 mittels eines Ladungsverstärkers Qv entladen werden.

In der dritten Phase L2 werden auf genau die gleiche Art und Weise wie in der ersten Phase L0 die beiden Anschlüsse der Kondensatoren zusammen an die Referenzspannungsquelle $V_{REF}$ angeschlossen, und die Kondensatoren Cs0, Cs1 dadurch auf die Referenzspannung $V_{REF}$ geladen.

In der vierten Phase L3 wird eine zweite Zeitspanne zunächst abgewartet. Nach dieser zweiten Zeitspanne, zu einem zweiten Zeitpunkt T2, wird der Ladungszustand der zwei Kondensatoren Cs0, Cs1 ermittelt, indem die Kondensatoren mittels eines Ladungsverstärkers Qv entladen werden. Der Ladungszustand von der zweiten Phase L1 und der Ladungszustand von der vierten Phase L3 werden voneinander subtrahiert zur Bildung einer Differenz auf eine ähnliche Art und Weise zu der Ladungsdifferenzbildung der letzten Phase des normalen Messablaufs. Möglichkeiten zur Entladung und Differenzbildung werden im Zusammenhang mit Fig. 9 näher beschrieben.

Fig. 8c ist eine graphische Darstellung der Spannung über den Kondensatoren Cs0, Cs1 im zeitlichen Verlauf. Die Zeitachsen in den Figuren Fig. 8a-c sollen einheitlich sein. Die in Fig. 8c gezeigte Änderung der Spannung entspricht daher den Änderungen, die während des in Fig. 8b gezeigten Messablaufs auftreten. In Fig. 8c sind vier Kurven A, B, C, D gezeigt, wobei die Kurven A, B, C, D die Spannungsänderungen für vier Fälle darstellen. In den vier Fällen hat der Verlustwiderstands-Wert vier verschiedene Größen. Kurve A zeigt den Fall, in dem der Verlustwiderstand am größten ist und Kurve D zeigt den Fall, in dem der Verlustwiderstand am kleinsten ist. Für die erste und dritte Phase L0, L2 des Messablaufs zur Bestimmung des Leckstroms zeigt Fig. 8c Kondensator-Aufladungskurven. Die Kurven A,B,C,D verhalten sich gleich, oder nahezu gleich, für diese Phasen L0, L2 in den vier verschiedenen Fällen. Diese werden daher mit nur einer Kurve dargestellt.

In den zweiten und vierten Phase L1, L3 werden Zeitspannen abgewartet. Die Entladungskurve für einen Kondensator, der parallel zu einem Widerstand/Verlustwiederstand geschaltet ist, ist dem Fachmann bekannt. Die Ladung Q(t) auf den Kondensatoren ist:

$$Q(t) = C* V_{REF} *exp(-t/RC),$$

wobei

C die Kapazität,
$V_{REF}$ der Referenzspannung,
t die Zeit und
R der Verlustwiderstands-Wert ist.

In Fig. 8c werden zunächst zu den zwei Zeitpunkten T1,T2 die Ladungszustände der Kondensatoren A1, B1, C1, D1 und A2, B2, C2, D2 bestimmt. Mittels der bestimmten Ladungszustände werden Differenzen der Ladungszustände für die vier verschiedenen Fälle erfasst.

Dem Fachmann ist bekannt, dass Methoden zur Entladung von Kondensatoren zur Bestimmung von Kapazitäten bzw. zur Bestimmung der Ladung auf Kondensatoren oder die Spannung über Kondensatoren vielfaltig sind. Ebenso sind die Möglichkeiten zur Bildungen einer Differenz der Ladungen oder Spannungen gleichwohl im analogen sowie digitalen Verfahren vielfältig. In Fig. 9 ist eine solche Möglichkeit zur Entladung der Kondensatoren dargestellt.

Fig. 9 zeigt ein Schaltdiagramm einer bevorzugten Ausführungsform der Vorrichtung zum Ausführen des erfindungsgemäßen Verfahrens. Die Eingangsschaltung 12 ist wieder genauso wie in Fig. 5 und Fig. 6 dargestellt. Die Eingangsschaltung 12 ist über einen zweiten Schalter S2 mit dem Ladungsverstärker Qv verbunden. Der Ladungsverstärker Qv weist einen Operationsverstärker Op mit einem invertierten Eingang E1 und einem nicht invertierten Eingang E2 auf. Der nicht invertierte Eingang E2 liegt auf Masse M, auf der auch die dritte Elektrode K3 der Eingangsschaltung 12 liegt. Der Operationsverstärker Op weist weiterhin einen Ausgang E3 auf, wobei der Ausgang E3 und der invertierte Eingang E1 des Operationsverstärkers Op über einen Rückkopplungspfad verbunden sind. Der Rückkopplungspfad weist ein drittes Schalterelement S3 sowie einen dem dritten Schalterelement S3 parallel geschalteten Ladungsmesskondensator $C_f$ auf.

Die in Fig. 9 dargestellte Schaltung funktioniert folgendermaßen. Die Schaltung wird in zwei Phasen verwendet Φ1, Φ2. In der erste Phase Φ1 wird der Ladungsmesskondensator $C_f$ entladen. Dies erfolgt über einen einfachen Kurzschluss über dem dritten Schalterelement S3. In der ersten Phase Φ1 wird also das dritte Schalterelement S3 geschlossen und dann wieder geöffnet.

In der zweiten Phase Φ2 wird das zweite Schalterelement S2 geschlossen. Dadurch, dass der nicht invertierte Eingang E2 des Operationsverstärkers Op an Masse M liegt, liegt der invertierte Eingang E1 an einer sogenannten "virtuellen Masse". Konsequenterweise wird die ganze Ladung, die auf den Kondensatoren Cs0, Cs1 der Eingangsschaltung 12 gelagert ist, gezwungen, sich auf den Ladungsmesskondensator $C_f$ zu verlagern. Die Ladung bewegt sich dabei in die von den Pfeilen gezeigte Richtung. Die Ausgangsspannung $V_0$ des Operationsverstärkers Op entspricht demnach der Spannung über dem Ladungsmesskondensator $C_f$, wobei diese Spannung direkt proportional der Ladung ist, die von der Eingangsschaltung übertragen wurde.

Eine Differenz der Ladungszustände kann mittels dieser Spannung erfasst werden. Beispielsweise kann die Spannung von einem ersten Durchgang dieser Phasen Φ1, Φ2 an eine Abtast-Halte-Schaltung angelegt werden und dann bei einem zweiten Durchgang von einer zweiten Spannung subtrahiert werden. In einem anderen Beispiel können die Spannungen gleich digitalisiert und dann mittels einer Auswerteeinheit bearbeitet werden. In einem weiteren Beispiel kann die Ladung von den Kondensatoren Cs1, Cs0 gleich auf dem Ladungsmesskondensator $C_f$ addiert oder subtrahiert werden, insbesondere indem die Kondensatoren Cs1, Cs0 das erste Mal mit der positiven Referenzspannung +Vref und das zweite Mal mit mit der negativen Referenzspannung -Vref aufgeladen werden. Eine fachlich qualifizierte Person würde verstehen, dass das erfindungsgemäße Verfahren mittels vieler Arten von Differenzbildungen ausgeführt werden kann.

Fig. 10 zeigt eine graphische Darstellung einer Differenzkurve in Abhängigkeit von dem Verlustwiderstand R[Leck], $R_L$. Die Y-Achse zeigt in diesem Fall einen Dezimalwert, der den Differenz-Wert repräsentiert. Der Differenz-Wert ist eine Differenz der Spannungen des Ladungsmesskondensators $C_f$ sowie der Betrag der Ladungsdifferenz der Sensorkondensatoren Cs1, Cs0 zu den zwei Zeitpunkten T1, T2. Ein Dezimalwert von ca. 32000 repräsentiert in dieser Abbildung keine Änderung des Ladungszustands der Kondensatoren.

Bei einem sehr niedrigen Verlustwiderstand $R_L$ werden die Kondensatoren vor dem ersten Zeitpunkt in der zweiten Phase L1 komplett entladen, und genauso vor den zweiten Zeitpunkt in der vierten Phase L3 komplett entladen. Es ist in diesem Fall keine Änderung zu erkennen. Darum ist der Differenz-Wert sehr niedrig. Bei einem sehr hohen Verlustwiderstand $R_L$ gibt es selbstverständlich ebenfalls wenig Veränderung des Ladungszustandes. In dieser graphischen Darstellung ist ein Wendepunkt bei 7MΩ vorgesehen. Liegt der Verlustwiderstand unter 7MΩ, kann eine Differenz des Ladungszustandes zu zwei Zeitpunkten T1, T2 keine Auskunft mehr über die Funktionstüchtigkeit des kapazitiven Sensors geben.

Die erwartete Änderung des Ladungszustandes der zwei Kondensatoren Cs0, Cs1 ist von der folgenden Formel abzuleiten:

$$\text{delta } Q(t) = C*Vref*( \exp(-T/RC) - \exp(-kT/RC) ),$$

wobei

    T der kürzere Zeitspanne entspricht, und
    kT der längere Zeitspanne entspricht, wobei die Dauer der längeren Zeitspanne genau dem k-fach der kürzeren Zeitspanne entspricht. Die Zeitspannen T, kT können ebenfalls als ein Takt T und eine Anzahl k von Takten kT interpretiert werden.

Weiterhin ist ein Schwellwert $S_{WERT}$ in Fig. 10 dargestellt, wobei der Schwellwert so festgelegt ist, dass eine Fehlermeldung ausgegeben wird, wenn der Verlustwiderstand unter 20 MΩ abfällt.

**Bezugszeichenliste**

1 Wirbelströmungsmessgerät
2 Messrohr
3 Staukörper
4 kapazitiver Sensor
5 Paddel
6 Membrane
7 Stab
8 zwei elektrische Drähte
9 erste Flanschverbindung
10 zweite Flanschverbindung
11 Rohr in einer Anlage
12 Eingangsschaltung
W1-6 Wirbel
S1-3 Schalterelement
Op Operationsverstärkers
E1-3 invertierter/nicht invertierter Eingang und Ausgang des Op
Qv Ladungsverstärker
$F_L$ Strömungsrichtung
$\xi$ charakteristische Breite des Staukörpers
d Innere Durchmesser des Messrohrs
K1-3 Kondensatorenelektroden
X1-2 Anschlüsse der Kondensatoren
Cs0, Cs1 erster/ zweiter Kondensator
$V_{REF}$ Referenzspannung, Referenzspannungsquelle
$R_L$,R[Leck] Verlustwiderstand
$S_{WERT}$ Schwellwert
P0-3 Phasen des normalen Messablaufs
G0-1 Phasen des Gesamtkapazitätsmessablaufs
L0-3 Phasen des Ablaufs zur Bestimmung eines Leckstroms
$\Phi$1-2 Phasen zum Verwenden einer Schaltung

**Patentansprüche**

1. Verfahren zur Überwachung eines Messgerätes (1) der Automatisierungstechnik, wobei das Messgerät (1) ein Wirbelströmungsmessgerät (1) ist mit einem Messrohr (2), einem im Messrohr angeordneten, wirbelerzeugenden Staukörper (3), einem dem Staukörper (3) zugeordneten kapazitiven Sensor (4), der vermittels zumindest eines Kondensators (Cs0, Cs1) die Wirbelablösefrequenz einer vom Staukörper (3) erzeugten Kármánschen Wirbelstraße aufnimmt,
wobei ein Verlustwiderstand ($R_L$) des zumindest einen Kondensators (CsO, Cs1) gemessen wird, indem der Ladungszustand des zumindest einen Kondensators (CsO, Cs1) zu einem ersten Zeitpunkt (T1) und zu einem nachfolgenden zweiten Zeitpunkt (T2) bestimmt wird,wobei der Verlustwiderstand ($R_L$) gemessen wird, indem der zumindest eine Kondensator (CsO, Cs1) mit einer Referenzspannung ($V_{REF}$) ein erstes Mal aufgeladen wird, die Ladung auf dem zumindest einen Kondensator (CsO, Cs1) nach einer ersten vorgegebenen Zeitspanne bestimmt wird, der zumindest eine Kondensator (CsO, Cs1) mit der Referenzspannung ($V_{REF}$) ein zweites Mal aufgeladen wird, die Ladung auf dem zumindest einen Kondensator (CsO, Cs1) nach einer zweiten vorgegebenen Zeitspanne bestimmt wird,
**dadurch gekennzeichnet, dass**
die zweite vorgegebene Zeitspanne kürzer als die erste vorgegebene Zeitspanne ist, sodass der entsprechende zweite Zeitpunkt (T2), zu dem die Bestimmung des Ladungszustandes des zumindest einen Kondensators (CsO, Cs1) durchgeführt wird, unmittelbar nach dem zweiten Aufladen des zumindest einen Kondensators (Cs0, Cs1) stattfindet,
und dass anhand einer Änderung des Ladungszustands zwischen dem ersten Zeitpunkt (T1) und dem zweiten Zeitpunkt (T2) eine Information über eine Störung der Funktionstüchtigkeit des Messgerätes (1) gewonnen wird.

2.  Verfahren nach Anspruch 1, **dadurch gekennzeichnet, dass** ein digitaler Diagnose-Wert zur Repräsentation der Änderung des Ladungszustands des zumindest einen Kondensators (CsO, Cs1) ermittelt wird, dass die Information über die Störung der Funktionstüchtigkeit des Messgerätes (1) gewonnen wird, indem der Diagnose-Wert mit einem vorgegebenen Schwellwert ($S_{WERT}$) verglichen wird, und dass eine Fehlermeldung generiert wird, wenn der vorgegebene Schwellwert ($S_{WERT}$) überschritten wird.

3.  Verfahren nach Anspruch 1, **dadurch gekennzeichnet, dass** eine Differenz der Ladungszustände des Kondensators (CsO, Cs1) zu den zwei aufeinanderfolgenden Zeitpunkten bestimmt wird, und dass aus der Differenz die Information über eine Störung der Funktionstüchtigkeit des Messgerätes (1) gewonnen wird.

4.  Verfahren nach Anspruch 3, **dadurch gekennzeichnet, dass** ein die Differenz der Ladungszustände repräsentierender digitaler Differenz-Wert ermittelt wird, dass die Information über eine Störung der Funktionstüchtigkeit des Messgerätes (1) gewonnen wird, indem der Differenz-Wert mit einem vorgegebenen Schwellwert ($S_{WERT}$) verglichen wird, und dass eine Fehlermeldung generiert wird, wenn der vorgegebene Schwellwert ($S_{WERT}$) überschritten wird.

5.  Verfahren nach Anspruch 5, **dadurch gekennzeichnet, dass** die erste Ladung, die auf dem zumindest einen Kondensator (CsO, Cs1) zu dem ersten Zeitpunkt (T1) bestimmt wird, sowie die zweite Ladung, die auf dem zumindest einen Kondensator (CsO, Cs1) zu dem zweiten Zeitpunkt (T2) bestimmt wird, auf einen Ladungsmesskondensator ($C_f$) übertragen wird, und dass die erste und zweite Ladung subtrahiert werden, sodass dabei eine Differenz der Ladungszustände elektronisch ermittelt wird.

6.  Verfahren nach einem oder mehreren der vorhergehenden Ansprüche, **dadurch gekennzeichnet, dass** der zumindest einen Kondensator (CsO, Cs1) vermittels einer Ladungspumpe mit einer genau bestimmten elektrischen Ladung aufgeladen wird.

7.  Verfahren nach einem oder mehreren der vorhergehenden Ansprüche, **dadurch gekennzeichnet, dass** ein Ladungszustand-Wert zur Repräsentation des Ladungszustands des Kondensators (CsO, Cs1) ermittelt wird, und dass der Ladungszustand-Wert zum ersten Zeitpunkt (T1) mit einem ersten vorgegebenen Grenzwert oder zum zweiten Zeitpunkt (T2) mit einem zweiten vorgegebenen Grenzwert verglichen wird, und aus diesem Vergleich die Information über eine Störung der Funktionstüchtigkeit des Messgerätes (1) gewonnen wird.

8.  Verfahren nach einem oder mehreren der vorhergehenden Ansprüche, wobei der Verlustwiderstand ($R_L$) des zumindest einen Kondensators (CsO, Cs1) im zeitlichen Verlauf aufgezeichnet wird, und anhand einer abfallenden Tendenz des Verlustwiderstandes ($R_L$) über die Zeit einer vorausschauenden Wartungsmeldung ausgelöst wird.

9.  Vorrichtung ausgeführt zur Durchführung des Verfahrens zur Überwachung der Funktionstüchtigkeit eines Messgerätes (1) nach einem oder mehreren der Ansprüche 1 bis 8, **dadurch gekennzeichnet, dass** das Messgerät (1) ein Wirbelströmungsmessgerät (1) ist mit einem Messrohr (2), einem im Messrohr angeordneten, wirbelerzeugenden Staukörper (3), einem dem Staukörper (3) zugeordneten kapazitiven Sensor (4), der vermittels des zumindest einen Kondensators (CsO, Cs1) die Wirbelablösefrequenz einer vom Staukörper (3) erzeugten Kármánschen Wirbelstraße aufnimmt, und einer Regel-/Auswerteeinheit, die den Verlustwiderstand ($R_L$) des zumindest einen Kondensators (CsO, Cs1) bestimmt und die Information über eine Störung der Funktionstüchtigkeit des Messgerätes (1) generiert.

10. Vorrichtung nach Anspruch 10, **dadurch gekennzeichnet, dass** die Regel-/Auswerteeinheit die Messung des Verlustwiderstandes ($R_L$) des zumindest einen Kondensators (CsO, Cs1) derart ausführt, dass die Zeitdauer zwischen dem Beginn des Aufladeverfahrens und dem zweiten Zeitpunkt des Aufladeverfahrens weniger als eine halbe Wirbelablöseperiode beträgt.

11. Vorrichtung nach Anspruch 9 oder 10, **dadurch gekennzeichnet, dass** das Messgerät (1) eine Schaltungsanordnung aufweist mit zwei Kondensatoren (CsO, Cs1), die sich an einen gemeinsamen Knoten oder einer gemeinsam Elektrode (K3) anschließen, wobei der gemeinsame Knoten oder die gemeinsame Elektrode (K3) an Masse (M) angeschlossen ist, dass die Kondensatoren (CsO, Cs1) an eine Referenzspannungsquelle ($V_{REF}$) über ein erstes Schalterelement (S1) angeschlossen sind, und dass die Kondensatoren (CsO, Cs1) an einen Ladungsverstärker (Qv) über ein zweites Schalterelement (S2) angeschlossen sind.

**12.** Vorrichtung nach Anspruch 11, **dadurch gekennzeichnet, dass** der Ladungsverstärker (Qv) in einer ASIC-Schaltung integriert ist.

**13.** Vorrichtung nach Anspruch 12, **dadurch gekennzeichnet, dass** die ASIC-Schaltung einen Analog/Digital-Wandler aufweist, der an dem Ladungsverstärker (Qv) angeschlossen ist, und dass der Analog/Digital-Wandler an einen als Auswerteinheit dienenden Mikrocontroller oder Signalprozessor angeschlossen ist.

**Claims**

**1.** Procedure to monitor a measuring device (1) used in automation engineering,
wherein the measuring device (1) is a vortex flowmeter with a measuring tube (2), a vortex-generating bluff body (3) arranged in the measuring tube, a capacitance sensor (4) assigned to the bluff body (3), said sensor recording, by means of at least one capacitor (CsO, Cs1), the vortex shedding frequency of a Karman vortex street generated by the bluff body (3),
wherein a loss resistance ($R_L$) of the at least one capacitor (CsO, Cs1) is measured by determining the charge state of the at least one capacitor (CsO, Cs1) at a first point in time (T1) and at a subsequent second point in time (T2), wherein the loss resistance ($R_L$) is measured by charging the at least one capacitor (CsO, Cs1) a first time with a reference voltage ($V_{REF}$), determining the charge at the at least one capacitor (CsO, Cs1) after a first predefined time period, charging the at least one capacitor (CsO, Cs1) a second time with the reference voltage ($V_{REF}$) and determining the charge at the at least one capacitor (CsO, Cs1) after a second predefined time period,
**characterized in that**
the second predefined time period is shorter than the first predefined time period, such that the corresponding second point in time (T2) when the charge state of the at least one capacitor (CsO, Cs1) is determined is immediately after the second charging of the at least one capacitor (CsO, Cs1),
and **in that**, on the basis of a change in the charge state between the first point in time (T1) and the second point in time (T2), information is obtained about a disruption in the operational reliability of the measuring device (1).

**2.** Procedure as claimed in Claim 1, **characterized in that** a digital diagnostic value is determined for representing the change in the charge state of the at least one capacitor (CsO, Cs1),
**in that** the information about the disruption in the operational reliability of the measuring device (1) is obtained by comparing the diagnostic value with a predefined threshold value ($S_{WERT}$), and
**in that** an error message is generated when the predefined threshold value (SWERT) is exceeded.

**3.** Procedure as claimed in Claim 1, **characterized in that** a difference in the charge states of the capacitor (CsO, Cs1) at the two consecutive points in time is determined, and
**in that** information about the disruption in the operational reliability of the measuring device (1) is obtained from the difference.

**4.** Procedure as claimed in Claim 3, **characterized in that** a digital difference value, which represents the difference in the charge states, is determined,
**in that** information about the disruption in the operational reliability of the measuring device (1) is obtained by comparing the difference value with a predefined threshold value ($S_{WERT}$), and
**in that** an error message is generated if the predefined threshold value ($S_{WERT}$) is exceeded.

**5.** Procedure as claimed in Claim 4, **characterized in that** the first charge, which is determined on the at least one capacitor (CsO, Cs1) at the first point in time (T1), and the second charge, which is determined on the at least one capacitor (CsO, Cs1) at the second point in time (T2), is transmitted to a charge measurement capacitor ($C_f$), and
**in that** the first and second charge are subtracted such that a difference in the charge states is determined electronically.

**6.** Procedure as claimed in one or more of the previous claims, **characterized in that** the at least one capacitor (CsO, Cs1) is charged with a precisely defined electrical charge using a charge pump.

**7.** Procedure as claimed in one or more of the previous claims, **characterized in that** a charge state value representing the charge state of the capacitor (CsO, Cs1) is determined, and **in that** the charge state value at the first point in time (T1) is compared with a first predefined limit value or at the second point in time (T2) with a second predefined limit value, and that information about the disruption in the operational reliability of the measuring device (1) is obtained from this comparison.

8. Procedure as claimed in one or more of the previous claims, wherein the loss resistance ($R_L$) of the at least one capacitor (CsO, Cs1) is recorded in the course of time and a predictive maintenance message is triggered on the basis of a downward trend in the loss resistance ($R_L$) over time.

9. Apparatus designed for performing the process for monitoring the operational reliability of a measuring device (1) as claimed in one or more of the Claims 1 to 8, **characterized in that** the measuring device (1) is a vortex flowmeter with a measuring tube (2), a vortex-generating bluff body (3) arranged in the measuring tube, a capacitance sensor (4) assigned to the bluff body (3), said sensor recording, by means of at least one capacitor (CsO, Cs1), the vortex shedding frequency of a Karman vortex street generated by the bluff body (3), and with a control/evaluation unit which determines the loss resistance ($R_L$) of the at least one capacitor (CsO, Cs1) and generates information about a disruption in the operational reliability of the measuring device (1).

10. Apparatus as claimed in Claim 9, **characterized in that** the control/evaluation unit measures the loss resistance ($R_L$) of the at least one capacitor (CsO, Cs1) in such a way that the time between the start of the charging process and the second point in time of the charging process is less than half a vortex shedding period.

11. Apparatus as claimed in Claim 9 or 10, **characterized in that** the measuring device (1) has a circuit arrangement with two capacitors (CsO, Cs1), which are connected to a common node or a common electrode (K3), wherein the common node or the common electrode (K3) is connected to ground (M),
**in that** the capacitors (CsO, Cs1) are connected to a reference voltage source ($V_{REF}$) via a first switch element (S1), and **in that** the capacitors (CsO, Cs1) are connected to a charge amplifier (Qv) via a second switch element (S2).

12. Apparatus as claimed in Claim 11, **characterized in that** the charge amplifier (Qv) is integrated into an ASIC circuit.

13. Apparatus as claimed in Claim 12, **characterized in that** the ASIC circuit has an analog/digital converter which is connected to the charge amplifier (Qv), and **in that** the analog/digital converter is connected to a microcontroller or signal processor that serves as an evaluation unit.

**Revendications**

1. Procédé destiné à la surveillance d'un appareil de mesure (1) de la technique d'automatisation, l'appareil de mesure (1) étant un débitmètre vortex (1) avec un tube de mesure (2), un corps de retenue (3) disposé dans le tube de mesure générant des tourbillons, un capteur capacitif (4) affecté au corps de retenue (3), lequel capteur mesure au moyen d'au moins un condensateur (Cs0, Cs1) la fréquence de détachement des tourbillons d'une allée de tourbillons de Kármán générée par le corps de retenue (3),
pour lequel une résistance ohmique($R_L$) de l'au moins un condensateur (Cs0, Cs1) est mesurée en ce que l'état de charge de l'au moins un condensateur (Cs0, Cs1) est déterminé à un premier instant (T1) et à un deuxième instant (T2) suivant, la résistance ohmique ($R_L$) étant mesurée en ce que l'au moins un condensateur (CsO, Cs1) est chargé une première fois avec une tension de référence ($V_{REF}$), la charge de l'au moins un condensateur (Cs0, Cs1) étant déterminée après une première période de temps prédéfinie, l'au moins un condensateur (Cs0, Cs1) étant chargé une deuxième fois avec la tension de référence ($V_{REF}$), la charge de l'au moins un condensateur (Cs0, Cs1) étant déterminée après une deuxième période de temps prédéfinie,
**caractérisé**
**en ce que** la deuxième période de temps prédéfinie est plus courte que la première période de temps prédéfinie, si bien que le deuxième instant (T2) correspondant, auquel la détection de l'état de charge de l'au moins un condensateur (Cs0, Cs1) est effectuée, a lieu immédiatement après la deuxième charge de l'au moins un condensateur (Cs0, Cs1),
et **en ce qu'**une information sur une dégradation de la capacité de fonctionnement de l'appareil de mesure (1) est obtenue au moyen d'un changement de l'état de charge entre le premier instant (T1) et le deuxième instant (T2).

2. Procédé selon la revendication 1, **caractérisé en ce qu'**une valeur de diagnostic numérique est déterminée pour la représentation du changement de l'état de charge de l'au moins un condensateur (Cs0, Cs1),
**en ce que** l'information sur la dégradation de la capacité de fonctionnement de l'appareil de mesure (1) est obtenue
**en ce que** la valeur de diagnostic est comparée avec une valeur seuil (SWERT) prédéfinie, et
**en ce qu'**un message d'erreur est généré lorsque la valeur seuil (SWERT) prédéfinie est dépassée.

3. Procédé selon la revendication 1, **caractérisé en ce qu'**une différence des états de charge du condensateur (Cs0, Cs1) est déterminée aux deux instants consécutifs, et
**en ce qu'**est tirée de la différence l'information sur la dégradation de la capacité de fonctionnement de l'appareil de mesure (1).

4. Procédé selon la revendication 3, **caractérisé en ce qu'**est déterminée une valeur de différence numérique représentant la différence des états de charge, **en ce que** l'information sur une dégradation de la capacité de fonctionnement de l'appareil de mesure (1) est obtenue **en ce que** la valeur de différence est comparée avec une valeur seuil (SWERT) prédéfinie, et
**en ce qu'**un message d'erreur est généré lorsque la valeur seuil (SWERT) prédéfinie est dépassée.

5. Procédé selon la revendication 4, **caractérisé en ce que** la première charge, qui est déterminée sur l'au moins un condensateur (Cs0, Cs1) au premier instant (T1),
ainsi que la deuxième charge, qui est déterminée sur l'au moins un condensateur (Cs0, Cs1) au deuxième instant (T2), est transmise à un condensateur de mesure de charge ($C_f$), et **en ce que** la première et la deuxième charge sont soustraites, de telle sorte qu'une différence des états de charge est déterminée électroniquement.

6. Procédé selon l'une ou plusieurs des revendications précédentes, **caractérisé en ce que** l'au moins un condensateur (Cs0, Cs1) est chargé au moyen d'une pompe de charge avec une charge électrique parfaitement définie.

7. Procédé selon l'une ou plusieurs des revendications précédentes, **caractérisé en ce qu'**une valeur d'état de charge est déterminée pour la représentation de l'état de charge du condensateur (Cs0, Cs1), et **en ce que** la valeur d'état de charge au premier instant (T1) est comparée avec un premier seuil prédéfini ou **en ce que** la valeur d'état de charge au deuxième instant (T2) est comparée avec un deuxième seuil prédéfini, et **en ce qu'**une information sur une dégradation de la capacité de fonctionnement de l'appareil de mesure (1) est déduite de cette comparaison.

8. Procédé selon l'une ou plusieurs des revendications précédentes, pour lequel la résistance ohmique ($R_L$) de l'au moins un condensateur (Cs0, Cs1) est enregistrée dans le temps, et un message de maintenance préventif est déclenché sur la base d'une tendance décroissante de la résistance ohmique ($R_L$) au fil du temps.

9. Dispositif conçu pour la réalisation du procédé destiné à la surveillance de la capacité de fonctionnement d'un appareil de mesure (1) selon l'une ou plusieurs des revendications 1 à 8, **caractérisé en ce que** l'appareil de mesure (1) est un débitmètre vortex (1) avec un tube de mesure (2), un corps de retenue (3) disposé dans le tube de mesure générant des tourbillons, un capteur capacitif (4) affecté au corps de retenue (3), lequel capteur mesure au moyen d'au moins un condensateur (Cs0, Cs1) la fréquence de détachement des tourbillons d'une allée de tourbillons de Kármán générée par le corps de retenue (3), et avec une unité de régulation / d'exploitation, qui détermine la résistance ohmique ($R_L$) de l'au moins un condensateur (Cs0, Cs1) et génère l'information sur une dégradation de la capacité de fonctionnement de l'appareil de mesure (1).

10. Dispositif selon la revendication 9, **caractérisé en ce que** l'unité de régulation / d'exploitation effectue la mesure de la résistance ohmique ($R_L$) de l'au moins un condensateur (Cs0, Cs1) de telle sorte que la durée entre le début du processus de charge et le deuxième instant du processus de charge est inférieure à une demi-période de détachement des tourbillons.

11. Dispositif selon la revendication 9 ou 10, **caractérisé en ce que** l'appareil de mesure (1) comporte une configuration de circuit avec deux condensateurs (Cs0, Cs1), qui sont connectés à un noeud commun ou à une électrode (K3) commune, le noeud commun ou l'électrode (K3) commune étant raccordé à la masse (M), **en ce que** les condensateurs (Cs0, Cs1) sont raccordés à une source de tension de référence ($V_{REF}$) à travers un premier élément de commutation (S1), et **en ce que** les condensateurs (Cs0, Cs1) sont raccordés à un amplificateur de charge (Qv) à travers un deuxième élément de commutation (S2).

12. Dispositif selon la revendication 11, **caractérisé en ce que** l'amplificateur de charge (Qv) est intégré dans un circuit ASIC.

13. Dispositif selon la revendication 12, **caractérisé en ce que** le circuit ASIC comporte un convertisseur analogique / numérique, qui est raccordé à l'amplificateur de charge (Qv), et **en ce que** le convertisseur analogique / numérique est raccordé à un microcontrôleur ou un processeur de signal servant d'unité d'exploitation.

**Fig. 1** (StdT.)

**Fig. 2** (StdT.)

**Fig. 3** (StdT.)

Fig. 4 (StdT.)

Fig. 5 (StdT.)

Fig. 6

**8 Takte**

a) | P0 | P1 | P2 | P3 | P2 | P1 | P2 | P3 | | |

b) | P0 | P1 | P2 | P3 | G0 | G1 |

Fig. 7

**16 Takte**

a) | P0 | P1 | P2 | P3 | P0 | P1 | P2 | P3 | P0 | P1 | P2 | P3 | P0 | P1 | P2 | P3 | P0 | P1 | P2 | P3 |

b) | L0 | L1 | L2 | L3 |

Zeit

$V_{ref}$

A1
B1
C1
D1 T1

A2
B2
C2
D2
T2

Zeit

Fig. 8

Fig. 9

Differenz (Spannung/Ladung) als Dezimalwert

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 03544198 A1
- US 8461849 B1
- WO 2009135764 A1
- US 20130207677 A1